# EUROPEAN PATENT APPLICATION

(11) **EP 4 716 383 A1**
(43) Date of publication of application: **25.03.2026**
(21) Application number: 25197883.9
(22) Date of filing: 25.08.2025
(51) Int. Cl.: H05K 1/03, H10W 70/69, H10W 70/692, H10W 70/652, H10W 70/68

(54) **PACKAGING SUBSTRATE AND MANUFACTURING METHOD THEREOF**

(30) Priority: 12.09.2024 US 202463693713 P
(71) Applicant: Absolics Inc., Covington, GA 30014 (US)
(72) Inventor: KIM, Hyejin, Covington, Georgia, 30014 (US); SHIN, Dongjun, Covington, Georgia, 30014 (US)
(74) Representative: BCKIP Part mbB

(57) **Abstract**

A packaging substrate according to the present disclosure comprises a core layer; a first conductive layer, which is a conductive layer disposed in contact with an upper surface of the core layer; and an adhesion reinforcement layer disposed on the core layer and surrounding at least a portion of the first conductive layer. The adhesion reinforcement layer comprises any one selected from the group consisting of a silicon-based compound, an acrylic-based compound, and a combination thereof. An arithmetic average roughness (Ra) value of the upper surface of the first conductive layer is 150 nm or less.

**In** this case, it is possible to effectively improve the adhesion strength of the insulating layer to the first conductive layer without excessively roughening the first conductive layer.

## Description

### TECHNICAL FIELD

The present disclosure relates to packaging substrates and manufacturing methods thereof.

### BACKGROUND

In the manufacture of electronic components, implementing a circuit on a semiconductor wafer is referred to as a front-end process (FE: Front-End), and assembling the wafer into a state usable as an actual product is referred to as a back-end process (BE: Back-End), which includes a packaging process.

The four core technologies of the semiconductor industry that have enabled the rapid advancement of electronic devices are semiconductor technology, semiconductor packaging technology, manufacturing process technology, and software technology. Semiconductor technology has evolved in various forms such as sub-micron or nanometer line widths, more than ten million cells, high-speed operation, and high heat emission. However, relatively speaking, the technology to perfectly package these has not kept pace. Accordingly, the electrical performance of semiconductors may be determined more by packaging technology and the associated electrical interconnections than by the semiconductor technology itself.

Ceramic or resin is applied as the material for the packaging substrate. In the case of a ceramic substrate, it is not easy to mount high-performance, high-frequency semiconductor devices due to its high resistance or high dielectric constant. In the case of a resin substrate, although it is relatively possible to mount high-performance, high-frequency semiconductor devices, there is a limitation in reducing the pitch of the wiring.

Recently, research is being conducted on applying silicon or glass as high-end packaging substrates. By forming through-holes in a silicon or glass substrate and applying a conductive material to these through-holes, the wiring length between the device and the motherboard can be shortened and excellent electrical characteristics can be obtained.

### SUMMARY

A packaging substrate according to one embodiment of the present specification includes a core layer, a first conductive layer disposed in contact with an upper surface of the core layer, and an adhesion reinforcement layer disposed on the core layer and surrounding at least a portion of an upper surface of the first conductive layer.

The adhesion reinforcement layer includes at least one selected from the group consisting of silicon-based compounds, acrylic-based compounds, and combinations thereof.

An arithmetic average roughness (Ra) of the upper surface of the first conductive layer is 150 nm or less.

The silicon-based compound may include a silicone resin.

A maximum height roughness (Ry) of the upper surface of the first conductive layer may be 200 nm or less.

The core layer may be a glass core layer.

The upper surface of the core layer may include an exposed region in which the first conductive layer is not formed.

The adhesion reinforcement layer may be disposed in contact with at least a portion of the exposed region.

The core layer may include a cavity portion that is a region where a device is mounted inside.

The cavity portion may include an opening disposed on an upper surface side of the core layer, a cavity inner surface extending in the thickness direction of the core layer from the opening, and a device mounting space surrounded by the cavity inner surface.

The packaging substrate may include a device disposed in the device mounting space.

The adhesion reinforcement layer may be disposed in contact with at least a portion of the upper surface of the device.

A thickness of the adhesion reinforcement layer may be 1 µm to 25 µm.

The packaging substrate may include an insulating layer disposed in contact with the adhesion reinforcement layer.

The packaging substrate may include a multilayer insulating layer comprising the adhesion reinforcement layer and the insulating layer.

An adhesive force between the first conductive layer and the multilayer insulating layer may be 300 gf/cm or more.

A method of manufacturing a packaging substrate according to another embodiment of the present specification includes: a preparation step of preparing a preliminary substrate including a core layer and a first conductive layer disposed in contact with an upper surface of the core layer; an adhesion reinforcement layer forming step of forming an adhesion reinforcement layer surrounding at least a portion of the upper surface of the first conductive layer; and a manufacturing step of manufacturing a packaging substrate from the preliminary substrate on which the adhesion reinforcement layer is formed.

A surface roughness Ra value of the upper surface of the first conductive layer is 150 nm or less.

The adhesion reinforcement layer includes at least one selected from the group consisting of silicon-based compounds, acrylic-based compounds, and combinations thereof.

The preparation step may include a surface roughness control process for adjusting the surface roughness of the upper surface of the first conductive layer.

The adhesion reinforcement layer forming step may include a placement process of placing a composition for preparing the adhesion reinforcement layer so as to surround at least a portion of the upper surface of the first conductive layer, and a heat treatment process of forming the adhesion reinforcement layer by heat-treating the composition.

The manufacturing step may include an insulating layer forming process of forming an insulating layer disposed in contact with the upper surface of the adhesion reinforcement layer.

### BRIEF DESCRIPTION OF THE DRAWINGS

FIG. 1 is a cross-sectional view illustrating a packaging substrate according to one embodiment of the present disclosure.
FIG. 2 is a cross-sectional view illustrating a packaging substrate according to another embodiment of the present disclosure.
FIG. 3 is a cross-sectional view illustrating a packaging substrate according to still another embodiment of the present disclosure.

### DETAILED DESCRIPTION

Hereinafter, embodiments will be described in detail with reference to the accompanying drawings so that those skilled in the art to which the present disclosure pertains may readily implement the disclosure. However, the present disclosure may be implemented in various different forms and is not limited to the embodiments described herein. Throughout the specification, like reference numerals denote like components.

Throughout the present specification, the expression "combinations thereof" included in Markush-type expressions refers to one or more mixtures or combinations selected from the group of elements listed in the expression, and is intended to mean that at least one selected from the group is included.

Throughout the present specification, terms such as "first," "second," or "A," "B" are used to distinguish between like elements. In addition, the singular expressions shall be understood to include the plural expressions unless clearly indicated otherwise by context.

In the present specification, "- based" may mean that a compound or derivative corresponding to "-" is included in the compound.

In the present specification, the meaning that B is positioned on A includes both cases where B is positioned directly in contact with A and where another layer is interposed therebetween, and shall not be construed as being limited to B being in contact with the surface of A.

In the present specification, the meaning that B is connected to A includes both direct connections and indirect connections through another component, unless otherwise stated, and shall not be construed as being limited to direct connections between A and B.

In the present specification, unless otherwise stated, singular expressions are to be construed to include both singular and plural meanings as interpreted in context.

In the present specification, the shape, relative size, angle, etc., of the components in the drawings may be exaggerated for illustrative purposes, and the scope of rights shall not be interpreted as being limited to the drawings.

In the present specification, that A and B are adjacent to each other means either that A and B are in contact with each other or that they are located close to each other without contact. The expression that A and B are adjacent shall not be interpreted as being limited to contact, unless otherwise specified.

Unless otherwise specified in the present specification, property values of the respective components in the packaging substrate are interpreted as being measured at room temperature. The room temperature is 20°C to 25°C.

Hereinafter, the embodiments will be described in detail.

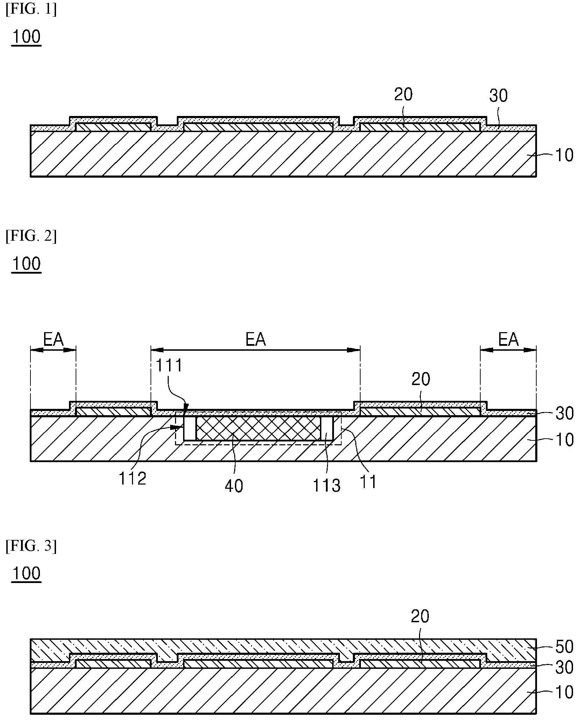

FIG. 1 is a cross-sectional view illustrating a packaging substrate according to one embodiment of the present disclosure. Hereinafter, the present disclosure will be described with reference to FIG. 1.

The packaging substrate 100 according to the present disclosure includes a core layer 10, a first conductive layer 20 which is a conductive layer disposed in contact with an upper surface of the core layer 10, and an adhesion reinforcement layer 30 disposed on the core layer 10 and surrounding at least a portion of an upper surface of the first conductive layer 20.

### [Core Layer]

The core layer 10 may have the shape of a substrate. A substrate applicable in the field of packaging substrates may be applied as the core layer 10.

The core layer 10 may include a through-via (not shown) penetrating in the thickness direction of the core layer 10.

The through-via consists of an internal space (not shown) and a via inner surface (not shown) surrounding the internal space. The internal space is a void, and the via inner surface refers to the surface of the core layer 10 formed inside the through-via.

The through-via may have a diameter that varies in the thickness direction of the core layer 10. The through-via may have a substantially uniform diameter in the thickness direction of the core layer 10.

The surface of the core layer 10 may include an upper surface and a side surface formed in the thickness direction of the core layer 10 connected to the upper surface. The surface of the core layer 10 may include a lower surface facing the upper surface.

That the side surface is formed in the thickness direction of the core layer 10 is to be interpreted to include not only the case where the side surface forms a right angle with the upper surface of the core layer 10 but also the case where at least a portion of the side surface forms an angle other than 90 degrees (inclined angle) with the upper surface.

The side surface may be a flat surface or a curved surface.

The core layer 10 may be a glass core layer. The glass core layer may have physical properties suitable for implementing a conductive layer having a fine pitch.

The glass core layer may have the shape of a glass substrate. For example, alkali borosilicate glass, alkali-free borosilicate glass, alkali-free alkali-earth borosilicate glass, etc., may be applied, and any glass substrate used for electronic components may be applicable. A glass substrate for electronic devices may be used as the glass core layer, and for example, products manufactured by Schott, AGC, or Corning may be applied, but are not limited thereto.

The thickness of the core layer 10 may be 100 µm or more. The thickness may be 200 µm or more. The thickness may be 300 µm or more. The thickness may be 3000 µm or less. The thickness may be 2000 µm or less. The thickness may be 1000 µm or less. In such a case, the core layer 10 may have mechanical properties suitable for being applied to the packaging substrate 100.

### [Conductive Layer]

The packaging substrate 100 may include a conductive layer disposed on the core layer 10. The conductive layer disposed in contact with the upper surface of the core layer 10 may include a first conductive layer 20 and a second conductive layer (not shown) disposed on the first conductive layer 20.

The conductive layer is a wire that transmits electrical signals. The conductive layer may have a patterned shape.

The conductive layer may include an electrically conductive material. The conductive layer may have a structure of one or more layers. The conductive layer may include a seed layer (not shown) and a conductor layer (not shown) formed on the seed layer.

The seed layer is disposed between the upper surface of the core layer 10 or the insulating layer (not shown) and the conductor layer and may improve the adhesion of the conductor layer to the upper surface of the core layer 10. The seed layer may include a first seed layer disposed in contact with the upper surface of the core layer 10 or the insulating layer, and a second seed layer disposed on the first seed layer. A material different from the material of the conductor layer may be applied to the first seed layer. For example, the first seed layer may include titanium, chromium, nickel, etc. The second seed layer may be made of the same material applied to the conductor layer. For example, the second seed layer may include copper.

The conductor layer may function as a signal transmission path within the packaging substrate 100. The conductor layer may include at least one of copper, nickel, aluminum, gold, or silver. Copper, for example, may be applied as the material of the conductor layer.

The first conductive layer 20 may include an upper surface. The arithmetic average roughness (Ra) of the upper surface of the first conductive layer 20 may be 40 nm or less.

In order to improve adhesion between the conductive layer and the insulating layer, it may be considered to form the surface of the conductive layer to be rough. However, if a conductive layer that is roughened beyond a certain level is subjected to high-frequency power, the resistance of the conductive layer may increase excessively due to the skin effect.

The present disclosure may control the surface roughness characteristics of the upper surface of the conductive layer, particularly the first conductive layer 20, to a certain level or less, and may introduce an adhesion reinforcement layer 30, which will be described below. Through this, a sufficient amount of the adhesion reinforcement layer may be retained on the upper surface of the first conductive layer 20, thereby improving the adhesion between the first conductive layer 20 and the insulating layer, and providing a first conductive layer 20 suitable for high-frequency power.

The arithmetic average roughness (Ra) of the upper surface of the first conductive layer 20 may be 150 nm or less. The Ra value may be 120 nm or less. The Ra value may be 100 nm or less. The Ra value may be 25 nm or more. The Ra value may be 35 nm or more. The Ra value may be 45 nm or more.

The maximum height roughness (Ry) of the upper surface of the first conductive layer 20 may be 200 nm or less. The Ry value may be 180 nm or less. The Ry value may be 160 nm or less. The Ry value may be 20 nm or more.

In such a case, the first conductive layer 20 may smoothly transmit signals even when high-frequency power is applied.

The Ra value and Ry value are measured according to the standards of ISO4287:1997.

The thickness of the first conductive layer 20 may be 10 µm or more. The thickness may be 15 µm or more. The thickness may be 20 µm or more. The thickness may be 50 µm or less.

The width of the first conductive layer 20 may be 10 µm or more. The width may be 15 µm or more. The width may be 20 µm or more. The width may be 50 µm or less.

In such a case, the packaging substrate 100 may help achieve high integration and stable electrical reliability.

The packaging substrate 100 may include a second conductive layer disposed on the first conductive layer 20. In terms of composition, roughness, and layer structure, the second conductive layer may be the same as the first conductive layer 20. Description of the composition, roughness, and layer structure of the second conductive layer is omitted as it overlaps with the above content.

The thickness and/or width of the second conductive layer may be equal to or less than that of the first conductive layer 20. The thickness and/or width of the second conductive layer may be smaller than that of the first conductive layer 20. In this case, a packaging substrate 100 that can be electrically connected to a device with ease may be provided.

The packaging substrate 100 may further include a third conductive layer disposed under the core layer 10. Description of the composition, roughness, and layer structure of the third conductive layer is omitted as it overlaps with the above content.

The thickness and/or width of the third conductive layer may be equal to or greater than that of the first conductive layer 20. The thickness and/or width of the third conductive layer may be greater than that of the first conductive layer 20. In this case, the packaging substrate 100 may perform smooth signal transmission with the motherboard.

### [Adhesion Reinforcement Layer]

In the present disclosure, an adhesion reinforcement layer 30 may be introduced on the upper surface side of the first conductive layer 20. The adhesion reinforcement layer 30 may be disposed between the first conductive layer 20 and the insulating layer. Even if the first conductive layer 20 has a relatively smooth surface, the adhesion reinforcement layer 30 may enable the insulating layer to have stable adhesion to the first conductive layer 20.

The adhesion reinforcement layer 30 may be disposed on the core layer 10. The adhesion reinforcement layer 30 may surround at least a portion of the upper surface of the first conductive layer 20. The adhesion reinforcement layer 30 may surround the upper surface of the first conductive layer 20. The adhesion reinforcement layer 30 may surround at least a portion of the side surface of the first conductive layer 20. The adhesion reinforcement layer 30 may surround the side surface of the first conductive layer 20.

The adhesion reinforcement layer 30 may be disposed in contact with the first conductive layer 20 and surround the first conductive layer 20. The adhesion reinforcement layer 30 may surround the first conductive layer 20 while being spaced apart from the first conductive layer 20.

The present disclosure may further include an adhesion reinforcement layer 30 introduced on the upper surface side of the second conductive layer. The adhesion reinforcement layer 30 may be disposed between the second conductive layer and the insulating layer. In such a case, the insulating layer may exhibit stable adhesion to the second conductive layer without excessive roughening of the second conductive layer.

The adhesion reinforcement layer 30 may surround at least a portion of the upper surface of the second conductive layer. The adhesion reinforcement layer 30 may surround the upper surface of the second conductive layer. The adhesion reinforcement layer 30 may surround at least a portion of the side surface of the second conductive layer. The adhesion reinforcement layer 30 may surround the side surface of the second conductive layer.

The adhesion reinforcement layer 30 may be disposed in contact with the second conductive layer and surround the second conductive layer. The adhesion reinforcement layer 30 may surround the second conductive layer while being spaced apart from the second conductive layer.

The adhesion reinforcement layer 30 formed in contact with the second conductive layer may be disposed on the adhesion reinforcement layer 30 formed in contact with the first conductive layer 20. The adhesion reinforcement layer 30 formed in contact with the second conductive layer may form a separate layer isolated from the adhesion reinforcement layer 30 formed in contact with the first conductive layer 20.

The upper surface of the core layer 10 may include an exposed region (EA) which is a region where the first conductive layer 20 is not formed. The adhesion reinforcement layer 30 may be disposed in contact with at least a portion of the exposed region (EA).

The upper surface of the core layer 10 may have a low roughness characteristic to implement fine patterns precisely. In such a case, an adequate anchor effect may not occur in the portion where the insulating layer is formed in contact with the core layer 10, and the insulating layer may not exhibit sufficient adhesion to the upper surface of the core layer 10.

In the present disclosure, the adhesion reinforcement layer 30 may be disposed in contact with at least a portion of the exposed region (EA), thereby helping the insulating layer to be stably maintained on the exposed region (EA).

The adhesion reinforcement layer 30 may be disposed in contact with at least a portion of the exposed region (EA). The adhesion reinforcement layer 30 may be disposed in contact with the exposed region (EA).

The adhesion reinforcement layer 30 disposed in contact with at least a portion of the exposed region (EA) may be connected to the adhesion reinforcement layer 30 surrounding at least a portion of the upper surface of the first conductive layer 20 to form a single layer. The adhesion reinforcement layer 30 disposed in contact with at least a portion of the exposed region (EA) may be formed to not be connected to the adhesion reinforcement layer 30 surrounding at least a portion of the upper surface of the first conductive layer 20.

FIG. 2 is a cross-sectional view illustrating a packaging substrate according to another embodiment of the present disclosure. Hereinafter, the present disclosure will be described with reference to FIG. 2.

The packaging substrate 100 includes a core layer 10, a first conductive layer 20 which is a conductive layer disposed in contact with the upper surface of the core layer 10, and an adhesion reinforcement layer 30 disposed on the core layer 10 and surrounding at least a portion of the upper surface of the first conductive layer 20. The components of the packaging substrate 100 are the same as those described in FIG. 1 above. The following description focuses on the differing parts.

The core layer 10 may include a cavity portion 11, which is a space inside where a device is mounted. The cavity portion 11 may include an opening 111 disposed on the upper surface side of the core layer 10, a cavity inner surface 112 formed by extending from the opening 111 in the thickness direction of the core layer 10, and a device mounting space 113 surrounded by the cavity inner surface 112.

That the cavity inner surface 112 is formed in the thickness direction of the core layer 10 is interpreted to include not only the case where the cavity inner surface 112 is perpendicular to the upper surface of the core layer 10, but also the case where at least a portion of the cavity inner surface 112 forms an angle other than 90 degrees (inclination angle) with respect to the upper surface.

The cavity inner surface 112 may be a flat surface or a curved surface.

The device mounting space 113 may be a space formed by recessing a portion of the upper surface in the thickness direction, when the core layer 10 is viewed from the upper side. The device mounting space 113 may have a shape penetrating in the thickness direction of the core layer 10. The device mounting space 113 may have a shape in which a portion of the core layer 10 is recessed in the thickness direction.

A device 40 may be mounted in the device mounting space 113 so that the packaging substrate 100 and the device 40 are electrically connected. The device 40 may be not only a semiconductor device such as a CPU, GPU, or memory chip, but also a capacitor device, transistor device, impedance device, or other module. That is, as long as it is a semiconductor device mounted in a semiconductor apparatus, it can be applied without limitation.

The present disclosure may form an adhesion reinforcement layer 30 on the upper surface side of the device 40. Through this, the insulating layer may be stably maintained on the cavity portion 11, and the packaging substrate 100 may contribute to stable electrical reliability.

The adhesion reinforcement layer 30 may be disposed in contact with at least a portion of the upper surface of the device 40. The adhesion reinforcement layer 30 may be disposed in contact with the upper surface of the device 40. The adhesion reinforcement layer 30 disposed in contact with at least a portion of the upper surface of the device 40 may be connected to the adhesion reinforcement layer 30 surrounding at least a portion of the upper surface of the first conductive layer 20 to form one layer. The adhesion reinforcement layer 30 disposed in contact with at least a portion of the upper surface of the device 40 may be formed separately from the adhesion reinforcement layer 30 surrounding at least a portion of the upper surface of the first conductive layer 20. The adhesion reinforcement layer 30 disposed in contact with at least a portion of the upper surface of the device 40 may be connected to the adhesion reinforcement layer 30 surrounding at least a portion of the exposed region (EA) to form one layer. The adhesion reinforcement layer 30 disposed in contact with at least a portion of the upper surface of the device 40 may be formed separately from the adhesion reinforcement layer 30 surrounding at least a portion of the exposed region (EA).

The adhesion reinforcement layer 30 may include at least one selected from the group consisting of silicon-based compounds, acrylic-based compounds, and combinations thereof. When such a composition is applied to the adhesion reinforcement layer 30, a chemical bond may be formed with the insulating layer when the adhesion reinforcement layer 30 is disposed in contact with the insulating layer in a high-temperature environment. Through this, it may contribute to further improving the adhesion of the insulating layer to the conductor layer.

The silicon-based compound may include a silicone resin. The silicon-based compound may be a silicone resin. The silicone resin may be formed by curing a silicone adhesive. The silicone resin may be formed by curing a silane compound. The silicone resin may be formed by curing a mixture of a silicone adhesive and a silane compound.

The silicone adhesive may be a peroxide-curing type silicone adhesive. The silicone adhesive may be an addition-reaction type silicone adhesive. The peroxide-curing type silicone adhesive and the addition-reaction type silicone adhesive are not particularly limited as long as they are commonly used in the adhesion or bonding technical field. For example, the peroxide-curing type silicone adhesive may be DOWSIL SH 4280 of Dow or KR-100 of Shin-Etsu. For example, the addition-reaction type silicone adhesive may be DOWSIL 4585 of Dow or KR-3700 of Shin-Etsu.

The silicon-based compound may include a silane compound. The silane compound may be a silane coupling agent, or a silane coupling agent having an additional functional group.

For example, the silane compound may include, at one terminal, for example, a methoxy group and/or an ethoxy group. In addition, the silane compound may include, at the other terminal, an amino group, vinyl group, epoxy group, methacryloxy group, acryloxy group, ureido group, mercapto group, sulfido group, or isocyanate group.

The acrylic-based compound may include an acrylic resin. The acrylic-based compound may be an acrylic resin. The acrylic resin may be formed by curing a compound including at least one selected from the group consisting of acrylic monomers, acrylic prepolymers, acrylic resins, and combinations thereof. The acrylic prepolymer may include an acrylate-based moiety. The acrylic resin may include an acrylate-based moiety. The acrylate-based monomer may be at least one selected from the group consisting of acrylate-based compounds, methacrylate-based compounds, alkyl group-containing acrylate-based compounds, alkyl group-containing methacrylate-based compounds, hydroxyl group-containing acrylate-based compounds, hydroxyl group-containing methacrylate-based compounds, siloxane-modified acrylate-based compounds, siloxane-modified methacrylate-based compounds, and combinations thereof. The acrylate-based moiety may be derived from at least one selected from the group consisting of acrylate-based compounds, methacrylate-based compounds, alkyl group-containing acrylate-based compounds, alkyl group-containing methacrylate-based compounds, hydroxyl group-containing acrylate-based compounds, hydroxyl group-containing methacrylate-based compounds, siloxane-modified acrylate-based compounds, siloxane-modified methacrylate-based compounds, and combinations thereof.

A thickness of the adhesion reinforcement layer 30 may be 1 µm to 25 µm. The thickness may be 3 µm or more. The thickness may be 5 µm or more. The thickness may be 10 µm or more. The thickness may be 20 µm or less. In such a case, it may help to maintain the adhesion between the insulating layer and the first conductive layer 20, etc., at a certain level or more.

### [Insulating Layer]

FIG. 3 is a cross-sectional view illustrating a packaging substrate according to still another embodiment of the present disclosure. Hereinafter, the present disclosure will be described with reference to FIG. 3.

The packaging substrate 100 includes a core layer 10, a first conductive layer 20 which is a conductive layer disposed in contact with the upper surface of the core layer 10, and an adhesion reinforcement layer 30 disposed on the core layer 10 and surrounding at least a portion of the upper surface of the first conductive layer 20. The components of the packaging substrate 100 are the same as those described in FIGS. 1 and 2 above. The following description focuses on the differing parts.

The packaging substrate 100 may further include an insulating layer 50 disposed on the first conductive layer 20. The insulating layer 50 may be disposed in contact with the adhesion reinforcement layer 30. Through this, the insulating layer 50 may be stably fixed to the first conductive layer 20 having a relatively smooth surface.

The insulating layer 50 may surround a portion of the first conductive layer 20. The insulating layer 50 may surround at least a portion of the upper surface of the first conductive layer 20. The insulating layer 50 may surround at least a portion of the side surface of the first conductive layer 20.

The insulating layer 50 and the first conductive layer 20 may be disposed together on the core layer 10. The first conductive layer 20, having a patterned shape, may be formed in an embedded form within the insulating layer 50.

The insulating layer 50 may surround at least a portion of the second conductive layer. The insulating layer 50 may surround at least a portion of the upper surface of the second conductive layer. The insulating layer 50 may surround at least a portion of the side surface of the second conductive layer.

The second conductive layer may be disposed together with the insulating layer 50. The second conductive layer, having a patterned shape, may be formed in an embedded form within the insulating layer 50.

The packaging substrate 100 according to the present disclosure may further include an insulating layer 50 disposed under the core layer 10. The insulating layer 50 may surround at least a portion of the third conductive layer. The insulating layer 50 may surround at least a portion of the upper surface of the third conductive layer. The insulating layer 50 may surround at least a portion of the side surface of the third conductive layer.

The third conductive layer may be disposed together with the insulating layer 50. The third conductive layer, having a patterned shape, may be formed in an embedded form within the insulating layer 50.

The insulating layer 50 is not limited as long as it is commonly applicable in the field of packaging substrates. For example, an epoxy-based resin including a filler may be applied as the insulating layer 50. For example, the insulating layer 50 may be formed using build-up layer materials such as Ajinomoto Build-up Film (ABF) from Ajinomoto, or undercoat materials, but is not limited thereto.

The insulating layer 50 may be formed by laminating an uncured or semi-cured insulating film and then curing the uncured or semi-cured insulating film.

The packaging substrate 100 may include a multilayer insulating layer comprising the adhesion reinforcement layer 30 and the insulating layer 50. The packaging substrate 100 may include a multilayer insulating layer consisting of the adhesion reinforcement layer 30 and the insulating layer 50. An adhesive force between the first conductive layer 20 and the multilayer insulating layer may be 300 gf/cm or more. The adhesive force may be 350 gf/cm or more. The adhesive force may be 400 gf/cm or more. The adhesive force may be 450 gf/cm or more. The adhesive force may be 500 gf/cm or more. The adhesive force may be 550 gf/cm or more. The adhesive force may be 600 gf/cm or more. The adhesive force may be 650 gf/cm or more. The adhesive force may be 1500 gf/cm or less. In such a case, a packaging substrate 100 having excellent durability and electrical reliability may be provided.

The adhesive force between the first conductive layer 20 and the multilayer insulating layer is measured by a bond tester using a 180° peel test. The measurement speed (peel speed) is set to 10 mm/s, and the measurement distance (peel distance) is set to 70 mm. For example, the adhesive force value may be measured using the Condor Sigma bond tester from XYZ TEC.

### [Other Components]

The packaging substrate 100 may further include a through-electrode (not shown) disposed in the through-via. The through-electrode may electrically connect the first conductive layer 20 and the third conductive layer. The same material and layer structure as those of the conductive layer may be applied to the through-electrode. The through-electrode may have a shape that completely fills the through-via, or may have a thin film shape in contact with the inner surface of the through-via.

The present disclosure may, as necessary, include an upper surface connection electrode (not shown) on the upper side of the packaging substrate 100 to electrically connect the device and the second conductive layer. The upper surface connection electrode may be directly connected via a terminal or the like to the device. The upper surface connection electrode may be connected to the device via a device connection part such as a solder ball.

The present disclosure may, as necessary, include a lower surface connection electrode (not shown) on the lower side of the packaging substrate 100 to electrically connect the motherboard and the third conductive layer. The lower surface connection electrode may be directly connected to the motherboard via a terminal or the like. The lower surface connection electrode may be connected to the motherboard via a connection part such as a bump.

In the present disclosure, a bump (not shown) may be disposed in a predetermined pattern under the third conductive layer, as necessary. The bump may be disposed in a certain area of the bottom surface of the packaging substrate 100 so as to be in contact with a motherboard or the like.

### [Semiconductor Package]

A semiconductor package according to another embodiment of the present disclosure includes a packaging substrate and a device electrically connected to the packaging substrate.

The packaging substrate may be mounted on a main board and electrically connected to the main board.

The packaging substrate and the device may be the same as those described above. Descriptions of the packaging substrate and the device are omitted as they overlap with the above.

### [Method for Manufacturing a Packaging Substrate

A method of manufacturing a packaging substrate according to another embodiment of the present disclosure includes: a preparation step of preparing a preliminary substrate including a core layer and a first conductive layer disposed in contact with an upper surface of the core layer; an adhesion reinforcement layer forming step of forming an adhesion reinforcement layer surrounding at least a portion of the upper surface of the first conductive layer; and a manufacturing step of manufacturing a packaging substrate from the preliminary substrate on which the adhesion reinforcement layer is formed.

A surface roughness Ra value of the upper surface of the first conductive layer is 40 nm or less.

The adhesion reinforcement layer includes a silicon-based compound.

In the preparation step, a preliminary substrate in which the first conductive layer has already been formed may be prepared, or the preliminary substrate may be prepared by forming the first conductive layer on the core layer.

Descriptions of the core layer and the first conductive layer are omitted as they overlap with the above.

The first conductive layer may be prepared by forming a first seed layer on the upper surface of the core layer, forming a second seed layer on the first seed layer, and then forming a conductor layer on the second seed layer.

The method of forming a seed layer on the core layer is not particularly limited as long as it is commonly applied in the field of packaging substrates. For example, the seed layer may be formed by a physical vapor deposition (PVD) process, sputtering process, electroless plating process, or the like.

Descriptions of the first seed layer and the second seed layer are omitted as they overlap with the above.

The conductor layer may be formed by performing a plating process on the second seed layer. The plating process is not particularly limited as long as it is a commonly used method in packaging substrates. For example, the plating process may be an electroless plating process.

Descriptions of the conductor layer are omitted as they overlap with the above.

Before forming the conductor layer, the seed layer may be patterned. Specifically, after forming a resist film on the seed layer, the resist film may be developed according to a pre-designed pattern shape, and then the conductor layer may be formed by a plating process. The resist film and development of the resist film are not particularly limited as long as they are commonly used in the field of packaging substrates.

Thereafter, the developed resist film may be removed, and the seed layer in the area where the conductor layer is not formed may be removed to complete formation of the first conductive layer. The seed layer may be removed through etching.

The preparation step may include a surface roughness control process for adjusting the roughness of the upper surface of the first conductive layer. **In** the surface roughness control process, the upper surface of the first conductive layer may be adjusted to have a roughness within a preset range in the present disclosure. Through this, it may contribute to improving adhesion between the insulating layer and the first conductive layer, while mitigating resistance increase in the first conductive layer due to the application of high-frequency power.

In the surface roughness control process, a method of oxidizing and reducing the upper surface of the first conductive layer may be applied. For example, the product Novabond from Atotech may be applied to oxidize and reduce the upper surface of the first conductive layer to control the roughness.

In the surface roughness control process, the upper surface of the first conductive layer may be etched. The etching may be wet etching or dry etching.

Descriptions of the roughness of the upper surface of the first conductive layer controlled through the surface roughness control process are omitted as they overlap with the above.

In the adhesion reinforcement layer forming step, an adhesion reinforcement layer may be formed to surround at least a portion of the upper surface of the first conductive layer. In addition, in the adhesion reinforcement layer forming step, the adhesion reinforcement layer may be formed to be in contact with at least a portion of the exposed region of the upper surface of the core layer, as described above. When the packaging substrate includes the cavity portion and the device mounted in the cavity portion, as described above, the adhesion reinforcement layer may be formed to be disposed in contact with at least a portion of the upper surface of the device in the adhesion reinforcement layer forming step.

Descriptions of the position, shape, thickness, and composition of the adhesion reinforcement layer are omitted as they overlap with the above.

The adhesion reinforcement layer forming step may include: a placement process of placing a composition for preparing the adhesion reinforcement layer so as to surround at least a portion of the upper surface of the first conductive layer; and a heat treatment process of forming the adhesion reinforcement layer by heat-treating the composition for preparing the adhesion reinforcement layer.

In the placement process, a multilayer film for preparing the adhesion reinforcement layer may be prepared in which the composition for preparing the adhesion reinforcement layer is disposed on a release film. The multilayer film may be laminated onto the preliminary substrate such that the surface on which the composition for preparing the adhesion reinforcement layer is disposed faces the upper surface of the first conductive layer, thereby placing the composition for preparing the adhesion reinforcement layer. However, the method of placing the composition for preparing the adhesion reinforcement layer is not limited thereto. Alternatively, the adhesion reinforcement layer may be formed by coating the composition for preparing the adhesion reinforcement layer on the upper surface of the first conductive layer and then curing the composition.

The composition for preparing the adhesion reinforcement layer may include a silicone adhesive. The composition for preparing the adhesion reinforcement layer may include a silane compound. The composition for preparing the adhesion reinforcement layer may include a silicone adhesive and a silane compound. Descriptions of the silicone adhesive and the silane compound are omitted as they overlap with the above.

The composition for preparing the adhesion reinforcement layer may include an acrylic-based compound. The acrylic-based compound may include at least one selected from the group consisting of acrylic-based monomers, acrylic-based prepolymers, acrylic-based resins, and combinations thereof. Descriptions of the acrylic-based monomer, acrylic-based prepolymer, and acrylic-based resin are omitted as they overlap with the above.

The composition for preparing the adhesion reinforcement layer may further include an additive commonly applied in the field of adhesion or bonding. For example, the composition for preparing the adhesion reinforcement layer may further include a curing agent, antioxidant, thermal stabilizer, and the like.

In the heat treatment process, the preliminary substrate on which the composition for preparing the adhesion reinforcement layer is placed is heat-treated to form the adhesion reinforcement layer, thereby further enhancing the adhesion of the adhesion reinforcement layer to the insulating layer.

In the heat treatment process, the heat treatment temperature may be 100°C or higher. The heat treatment temperature may be 110°C or higher. The heat treatment temperature may be 120°C or higher. The heat treatment temperature may be 130°C or higher. The heat treatment temperature may be 250°C or lower.

In the heat treatment process, the heat treatment time may be 10 seconds or longer. The heat treatment time may be 15 seconds or longer. The heat treatment time may be 20 seconds or longer. The heat treatment time may be 30 seconds or longer. The heat treatment time may be 30 minutes or shorter. The heat treatment time may be 20 minutes or shorter. The heat treatment time may be 10 minutes or shorter.

In such a case, the adhesion of the adhesion reinforcement layer to the insulating layer may be further improved.

In the manufacturing step, the packaging substrate may be manufactured from the preliminary substrate on which the adhesion reinforcement layer is formed.

The manufacturing step may include an insulating layer forming process of forming an insulating layer disposed in contact with the upper surface of the adhesion reinforcement layer.

After laminating an insulating film for forming the insulating layer on the adhesion reinforcement layer that has been heat-treated, the insulating layer may be formed by curing the insulating film for forming the insulating layer. Alternatively, the insulating layer may be formed by coating a composition for forming the insulating layer on the adhesion reinforcement layer and curing the composition.

The insulating film or the composition for forming the insulating layer is not particularly limited as long as it is commonly used in the field of build-up. Specifically, the insulating film or the composition for forming the insulating layer may be an epoxy-based resin film or composition.

The insulating layer may be formed in contact with the upper surface of the adhesion reinforcement layer. The insulating layer may be formed so as to surround the upper surface of the core layer.

The present disclosure may, as necessary, form a second conductive layer on the insulating layer. The second conductive layer may be formed in the same manner as the method of forming the first conductive layer, except that a predetermined width and thickness are applied.

An adhesion reinforcement layer may be formed to surround at least a portion of the upper surface of the second conductive layer. The adhesion reinforcement layer may be formed in the same manner as the method of forming the adhesion reinforcement layer surrounding at least a portion of the upper surface of the first conductive layer.

After forming the adhesion reinforcement layer on the second conductive layer, an insulating layer disposed in contact with the upper surface of the adhesion reinforcement layer may be formed. The insulating layer may be formed in the same manner as described above.

As necessary, under the glass core, a third conductive layer, an adhesion reinforcement layer surrounding at least a portion of the upper surface of the third conductive layer, and an insulating layer surrounding the adhesion reinforcement layer may be formed. The third conductive layer may be formed in the same manner as the method of forming the first conductive layer and/or the second conductive layer. However, in terms of width and/or thickness, the third conductive layer may be different from the first conductive layer or the second conductive layer.

The method for manufacturing the packaging substrate may further include a process of forming a connection terminal, bump, or cover layer on the upper surface and/or lower surface of the packaging substrate, or a process of mounting a device on the substrate.

Hereinafter, the present disclosure will be described in more detail through specific examples. The following examples are merely provided to aid the understanding of the present disclosure, and the scope of the present disclosure is not limited thereto.

### [Manufacture Example: Formation of Packaging Substrate]

Example 1: A first seed layer, which is a titanium layer having a thickness of 150 nm, was formed on a core layer made of a glass substrate via PVD, and a second seed layer, which is a copper layer having a thickness of 150 nm, was formed on the first seed layer via PVD.

A conductor layer, which is a copper layer having a thickness of 30 µm, was formed on the seed layer for forming the conductor layer via an electroless plating process to form a first conductive layer.

The upper surface of the first conductive layer was roughened using the product Novabond from Atotech to prepare a preliminary substrate. Thereafter, the Ra value of the roughened upper surface of the first conductive layer was measured in accordance with the provisions of standard ISO4287:1997. API Carrier Adhesive Tape AS-020PI12 model from Nitto Denko was attached on the roughened upper surface of the first conductive layer.

After heat-treating the preliminary substrate, on which the adhesion reinforcement layer was formed, at 150°C for 30 seconds to 5 minutes, a polyimide film, which was a release film, was removed to form the adhesion reinforcement layer.

A build-up layer from Ajinomoto was laminated on the adhesion reinforcement layer, and then cured at 150°C for 60 minutes to form an insulating layer, thereby completing the packaging substrate.

Example 2: A packaging substrate was fabricated under the same conditions as in Example 1, except that the upper surface of the first conductive layer was roughened using an etching solution of the CZ8101 model from MAC.

Example 3: A packaging substrate was fabricated under the same conditions as in Example 1, except that the upper surface of the first conductive layer was not roughened but instead was coated by vacuum deposition of a silane coupling agent, 3-methacryloxypropyltrimethoxysilane, at a thickness of 2 nm to 3 nm.

Comparative Example 1: A packaging substrate was fabricated under the same conditions as in Example 1, except that the upper surface of the first conductive layer was not subjected to separate roughening or surface treatment using a compound.

The Ra values measured from the upper surface of the first conductive layer in each Example and Comparative Example are described in Table 1 below.

### [Evaluation Example: Adhesion Strength Evaluation Between First Conductive Layer and Multilayer Insulating Layer]

The adhesion strength between the first conductive layer and the multilayer insulating layer (composed of the adhesion reinforcement layer and the insulating layer) was measured using the Condor Sigma bond tester from XYZ TEC according to a 180° peel test. The measurement speed (peeling speed) was set to 10 mm/s, and the measurement distance (peeling distance) was set to 70 mm.

The measured values for each Example and Comparative Example are described in Table 1 below.

### [Evaluation Example: Long-Term Durability Evaluation]

The packaging substrates of each Example and Comparative Example were left at 150°C for 1000 hours, and then the occurrence of delamination of the insulating layer from the core layer was evaluated. If no delamination of the insulating layer occurred, it was evaluated as P, and if delamination occurred, it was evaluated as F.

The measured values for each Example and Comparative Example are described in Table 1 below.

**[Table 1]**

| | Ra (nm) | Adhesion Strength(gf/cm) | Durability Evaluation |
|---|---|---|---|
| Example 1 | 50~80 | 820 | P |
| Example 2 | 50~80 | 550 | P |
| Example 3 | 50~80 | 420 | P |
| Comparative Ex. 1 | 20 | 160 | F |

As shown in Table 1 above, Examples 1 to 3 exhibited adhesion strength of 400 gf/cm or higher and were evaluated as P in the durability evaluation, whereas Comparative Example 1 exhibited adhesion strength of 200 gf/cm or lower and was evaluated as F in the durability evaluation. This is considered to be because, in Comparative Example 1, roughening of the surface of the first conductive layer was not performed, and therefore, the adhesion reinforcement layer did not sufficiently remain on the surface of the first conductive layer, resulting in the insulating layer not being stably adhered to the first conductive layer.

Although the preferred examples of the present disclosure have been described in detail above, the scope of the rights of the present disclosure is not limited thereto, and various modifications and improved forms by those skilled in the art using the basic concept defined in the following claims also fall within the scope of rights of the present disclosure.

## Claims

1. A packaging substrate comprising:
a core layer;
a first conductive layer, which is a conductive layer disposed in contact with an upper surface of the core layer; and
an adhesion reinforcement layer disposed on the core layer and surrounding at least a portion of an upper surface of the first conductive layer,
wherein the adhesion reinforcement layer comprises any one selected from the group consisting of a silicon-based compound, an acrylic-based compound, and a combination thereof,
and an arithmetic average roughness (Ra) value of the upper surface of the first conductive layer is 150 nm or less.

2. The packaging substrate of claim 1,
wherein the silicon-based compound comprises a silicone resin.

3. The packaging substrate of claim 1,
wherein a maximum height roughness (Ry) value of the upper surface of the first conductive layer is 200 nm or less.

4. The packaging substrate of claim 1,
wherein the core layer is a glass core layer,
an upper surface of the core layer comprises an exposed area which is a region where the first conductive layer is not formed,
and the adhesion reinforcement layer is disposed in contact with at least a portion of the exposed area.

5. The packaging substrate of claim 1,
wherein the core layer comprises a cavity portion which is a region in which a device is mounted, the cavity portion comprises an opening disposed on an upper surface side of the core layer,
a cavity inner surface formed to extend in a thickness direction from the opening of the core layer, and
a device mounting space surrounded by the cavity inner surface,
wherein the packaging substrate comprises a device disposed in the device mounting space,
and the adhesion reinforcement layer is disposed in contact with at least a portion of an upper surface of the device.

6. The packaging substrate of claim 1,
wherein a thickness of the adhesion reinforcement layer is 1 µm to 25 µm.

7. The packaging substrate of claim 1,
further comprising an insulating layer disposed in contact with the adhesion reinforcement layer.

8. The packaging substrate of claim 7,
wherein the packaging substrate comprises a multilayer insulating layer comprising the adhesion reinforcement layer and the insulating layer,
and an adhesion strength between the first conductive layer and the multilayer insulating layer is 300 gf/cm or more.

9. A method of manufacturing a packaging substrate, comprising:
a preparation step of preparing a preliminary substrate comprising a core layer and a first conductive layer disposed in contact with an upper surface of the core layer;
an adhesion reinforcement layer formation step of forming an adhesion reinforcement layer surrounding at least a portion of an upper surface of the first conductive layer; and
a manufacturing step of manufacturing a packaging substrate from the preliminary substrate on which the adhesion reinforcement layer is formed,
wherein a surface roughness Ra value of the upper surface of the first conductive layer is 150 nm or less,
and the adhesion reinforcement layer comprises any one selected from the group consisting of a silicon-based compound, an acrylic-based compound, and a combination thereof.

10. The method of claim 9,
wherein the preparation step comprises a surface roughness control process for adjusting a roughness of the upper surface of the first conductive layer.

11. The method of claim 9,
wherein the adhesion reinforcement layer formation step comprises:
a placement process of placing a composition for forming the adhesion reinforcement layer so as to surround at least a portion of the upper surface of the first conductive layer; and
a heat treatment process of heat-treating the composition for forming the adhesion reinforcement layer to form the adhesion reinforcement layer.

12. The method of claim 9,
wherein the manufacturing step comprises an insulating layer formation process of forming an insulating layer disposed in contact with an upper surface of the adhesion reinforcement layer.
